# EUROPÄISCHE PATENTSCHRIFT

(11) **EP 0 337 223 B1**
(45) Veröffentlichungstag und Bekanntmachung des Hinweises auf die Patenterteilung: **22.01.1997**
(21) Anmeldenummer: 89105769.7
(22) Anmeldetag: 01.04.1989
(51) Int. Cl.: H03F 1/30, H03F 3/343

(54) **Schaltungsanordnung zur Arbeitspunkteinstellung eines Transistors**
Circuit arrangement for working point adjustment of a transistor
Circuit pour l'ajustement du point de fonctionnement d'un transistor

(30) Priorität: 11.04.1988 DE 3811950
(43) Veröffentlichungstag der Anmeldung: 18.10.1989
(73) Patentinhaber: TEMIC TELEFUNKEN microelectronic GmbH, 74072 Heilbronn (DE)
(72) Erfinder: Rinderle, Heinz, D-7100 Heilbronn (DE)
(74) Vertreter: Maute, Hans-Jürgen, Dipl.-Ing.

(56) Entgegenhaltungen:
- DE-A- 3 744 751
- US-A- 4 238 738
- US-A- 4 742 309
- IEEE JOURNAL OF SOLID-STATE CIRCUITS, Band CS-6, Nr. 1, Februar 1971, Seiten 35-44; E.L. LONG et al.: "High-gain 15-W monolithic power amplifier with internal fault protection"
- PATENT ABSTRACTS OF JAPAN, Band 9, Nr. 305 (E-363)[2028] 3. Dezember 1985 & JP-A-60 144 008

## Beschreibung

Die Erfindung befaßt sich mit der Arbeitspunkteinstellung von Transistoren, insbesondere bipolaren Transistoren, in einer integrierten Schaltung, bei der die Kollektorströme der Transistoren durch die Basis-Emitterströme vorgegeben werden. Diese Basis-Emitterströme können beispielsweise durch Widerstände festgelegt werden, über die die Basis-Emitterstrecken von einer Versorgungsspannung gespeist werden. Eine solche Arbeitspunkteinstellung hat den Vorteil, daß relativ kleine Betriebsspannungen bei einem Minimum an Betriebsstrom ermöglicht werden. Die mögliche kleine Betriebsspannung ist dadurch bedingt, daß die Emitterpotentiale, z.B. von npn-Transistoren, direkt mit dem negativen Pol der Versorgungsspannung verbunden werden können. Der minimale Betriebsstrom ist deshalb möglich, weil neben den für die Funktion der Schaltung erforderlichen Kollektorströmen, nur die Basis-Emitterströme zusätzlich erforderlich sind. Die Nachteile einer solchen Arbeitspunkteinstellung bestehen darin, daß, bei vorgegebenen Widerständen für die Arbeitspunkteinstellung, die Kollektorströme von den Stromverstärkungsfaktoren der Transistoren und von den sich einstellenden Basis-Emitterspannungen abhängen.

Im allgemeinen werden zum Arbeitspunkteinstellen von Transistoren gegenkoppelnde Anordnungen wie z.B. die Emittergegenkopplung verwendet, bei der ein emitterstromstabilisierender Widerstand vorgesehen ist und bei der der Basis ein festes Potential zugeführt wird.

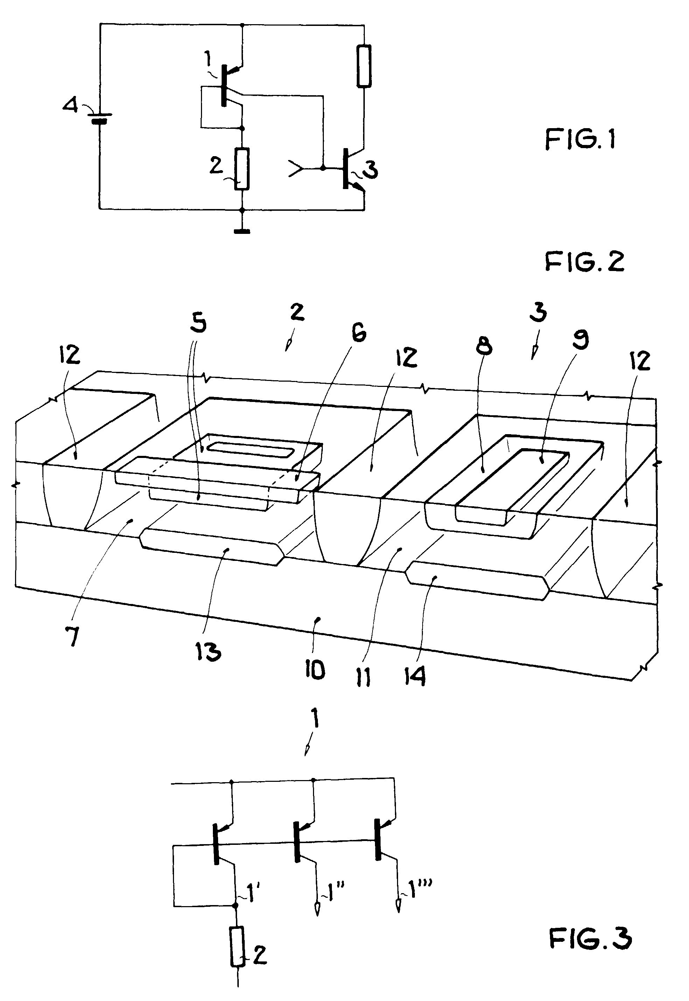

Die Figur 1 zeigt eine Schaltungsanordnung, bei der eine aus dem Transistor 1 bestehende Stromspiegelschaltung zusammen mit dem Widerstand 2 die Basis-Emitterströme zur Einstellung des Kollektorstromes des Transistors 3 liefert. Die Stromspiegelschaltung übersetzt den im Widerstand 2 fließenden Strom in einem bestimmten Verhältnis (Spiegelverhältnis) in den Kollektorstrom des Kollektors des Transistors 1 um. Das jeweilige Stromspiegelverhältnis wird dabei von der Ausbildung des Spiegeltransistors 1 bestimmt. Im Ausführungsbeispiel der Figur 1 ist der Spiegeltransistor 1 ein lateraler pnp-Transistor mit mehreren Kollektorsegmenten. Die Größe des Stromes, der durch den Widerstand 2 fließt, wird durch die Versorgungsspannung der Quelle 4, der Basis-Emitterspannung des Transistors 1 und vom Wert des Widerstandes 2 bestimmt. Dagegen beeinflußt der Stromverstärkungsfaktor des Transistors 1 das Stromspiegelverhältnis relativ wenig. Der Widerstand 2 ist ein sogenannter Pinchwiderstand, der zusammen mit dem Transistor 3 hergestellt wird. Ein Pinchwiderstand besteht gemäß der Figur 2 aus einer Widerstandszone 5, die von zwei Halbleiterzonen 6 und 7 in vertikaler Richtung begrenzt wird. Die Halbleiterzonen 6 und 7 haben den entgegengesetzten Leitungstyp wie die Widerstandszone 5. Die Widerstandszone 5 wird im gleichen Verfahrensschritt wie die Basiszone 8 des in der Figur 2 neben dem Pinchwiderstand befindlichen Transistor 3 hergestellt, so daß die Widerstandszone 5 den gleichen Leitungstyp, die gleiche Leitfähigkeit und die gleiche Eindringtiefe wie die Basiszone 8 des Transistors 3 aufweist. In analoger Weise wird die über der Widerstandszone 5 liegende Halbleiterzone 6, die an die Halbeiteroberfläche grenzt, im gleichen Arbeitsgang wie die Emitterzone 9 des Transistors 3 hergestellt, so daß die Halbleiterzone 6 den gleichen Leitungstyp, die gleiche Leitfähigkeit sowie die gleiche Tiefe wie die Emitterzone 9 des Transistors 3 aufweist. Der Halbleiterkörper der integrierten Schaltungsanordnung der Figur 2 besteht aus einem Substrat 10 vom ersten Leitungstyp und einer epitaktischen Schicht 11 vom zweiten Leitungstyp. Die elektrische Trennung der Bauelemente der Schaltungsanordnung der Figur 2 erfolgt durch Separationszonen 12, die den ersten Leitungstyp aufweisen. Die Widerstandszone 5 und die Basiszone 8 haben den ersten Leitungstyp. Unter dem Pinchwiderstand 2 und unter dem Transistor 3 befinden sich vergrabene Schichten 13 und 14 vom zweiten Leitungstyp.

Die Verwendung eines Pinchwiderstandes hat den Vorteil, daß dessen Widerstandswert mit dem Stromverstärkungsfaktor (H_{FE}) des mitintegrierten (npn)-Transistors 3 derart korreliert ist, daß der Widerstandswert des Pinchwiderstandes 2 im wesentlichen dem Stromverstärkungsfaktor des (npn)-Transistors 3 proportional ist. Unter diesen Umständen ist es in der gezeigten Schaltung möglich, den durch die Streuung des Stromverstärkungsfaktors (F_{FE}) bedingten Einfluß auf den Kollektorstrom des Transistors 3 durch die gegenläufig wirkende Streuung des Pinchwiderstandes 2 zu kompensieren.

Der Wert der Versorgungsspannung 4 hat Einfluß auf den Temperaturgang des eingestellten Kollektorstromes. Für weitgehende Temperaturabhängigkeit des Kollektorstromes des Transistors 3 gibt es ein Optimum für den Wert der Versorgungsspannung der Quelle 4. Dies beruht darauf, daß der Temperaturgang des Pinchwiderstandes 2 stark positiv und der Temperaturgang der Basis-Emitterspannung von Transistoren, und damit auch des Transistors 3, bekanntlich negativ ist (ca. -2 mV/K). Damit ist es möglich, nicht nur den Temperaturgang des Kollektorstromes zu kompensieren, sondern sowohl einen positiven als auch einen negativen Temperaturgang für den Kollektorstrom des Transistors 3 einzustellen.

Wie aus der Figur 1 ersichtlich, ist es nicht erforderlich, das Emitterpotential des Transistors 3 auf Bezugspotential festzulegen, da die Basis-Emitterstrom-Einspeisung in den Transistor 3 vom Emitterpotential des Transistors 3 weitgehend unabhängig ist, sofern der Stromspiegeltransistor 1 nicht in die Sättigung gesteuert wird.

Die Figur 3 zeigt einen weiteren Ausschnitt der Schaltung nach Figur 3, bei dem an Stelle eines lateralen pnp-Transistors mit mehreren Kollektorsegmenten mehrere pnp-Transistoren (1', 1", 1‴) verwendet werden können.

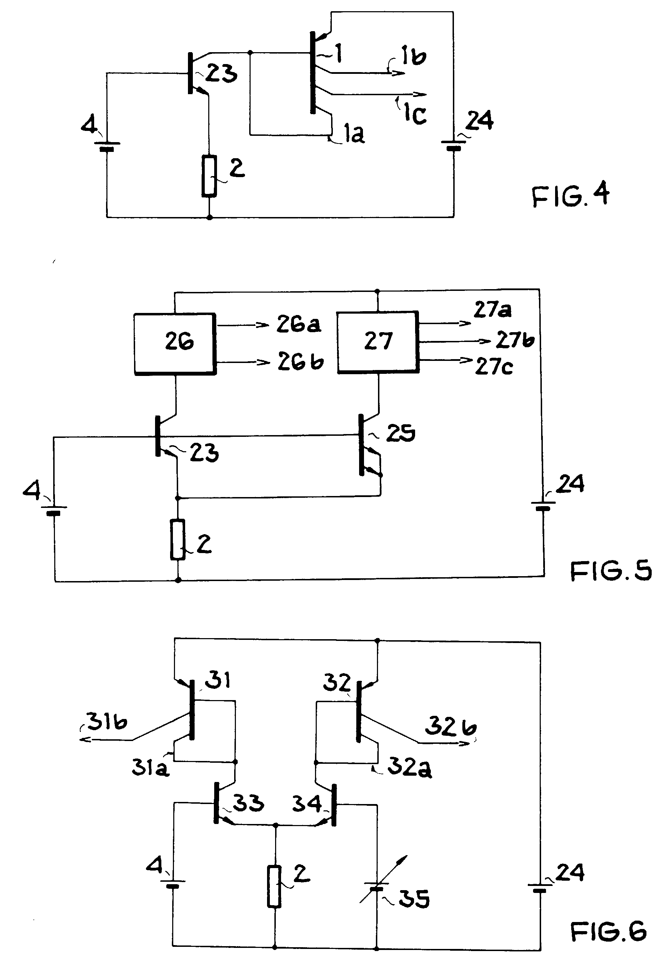

Die Figur 4 zeigt eine Schaltung nach dem Stand der Technik wie er aus PATENT ABSTRACTS OF JAPAN, Band 9, Nr. 305 (E-363) 2028, 03.12.1985 und JP-A 60/44008 bekannt ist. Der zu spiegelnde Strom für die Stromspiegelschaltung 1 stammt vom Kollektor des Transistors 23. Der Kollektorstrom dieses Transistors 23 ist praktisch gleich seinem Emitterstrom, der über die Versorgungsspannung der Quelle 4 in Verbindung mit der Reihenschaltung aus der Basis-Emitterstrecke des Transistors 23 und dem Widerstand 2 entsteht. Da die Stromspiegelanordnung mit dem Transistor 1 mit seinem Emitteranschluß auf die Versorgungsspannungsquelle 24 bezogen werden kann, können größere Potentialunterschiede für die von der Stromspiegelschaltung 1 über die Kollektoren 1b und 1c angesteuerten Basen verwirklicht werden.

Der Erfindung liegt die Aufgabe zugrunde, eine Schaltungsanordnung zur Arbeitspunkteinstellung eines Transistors anzugeben, die die Möglichkeit bietet, daß die Elektroden der Transistoren unterschiedliche Potentiale annehmen können, wodurch ein Freiheitsgrad bezüglich der Bemessung derjenigen Stufe erzielt wird, in der die Transistoren Anwendung finden. Diese Aufgabe wird bei einer Schaltungsanordnung zur Arbeitsstabilisierung eines Transistors nach dem Oberbegriff des Anspruchs 1 durch die Kennzeichen angegebenen Merkmale gelöst.

Die Erfindung wird im folgenden an Ausführungsbeispielen erläutert.

Die Figur 5 zeigt ein Ausführungsbeispiel nach der Erfindung. Bei der Anordnung nach Figur 5 ist der Basis-Emitterstrecke des Transistors 23 die Basis-Emitterstrecke eines weiteren Transistors 25 parallel geschaltet, dessen Emitterfläche, wie in Figur 5 angedeutet, z.B. doppelt so groß ist wie die Emitterfläche des Transistors 23. Die Kollektoren der Transistoren 23 und 25 sind mit den symbolisch dargestellten Stromspiegelanordnungen 26 bzw. 27 verbunden. Diese Stromspiegelanordnungen liefern an ihren Ausgängen (26a, 26b, bzw. 27a, 27b und 27c) jeweils die Basis-Emitterströme für die Einstellung der Kollektorströme von npn-Transistoren (nicht dargestellt). Die Aufgabe dieser Schaltung besteht darin, die zu den Stromspiegelschaltungen 26 und 27 geleiteten Ströme entsprechend dem Flächenverhältnis der Emitterflächen der Transistoren 23 und 25 zu verteilen. Im vorliegenden Beispiel wird 1/3 des im Pinchwiderstand 2 entstehenden Stromes in die Stromspiegelschaltung 26, und 2/3 in die Stromspiegelschaltung 27 geleitet.

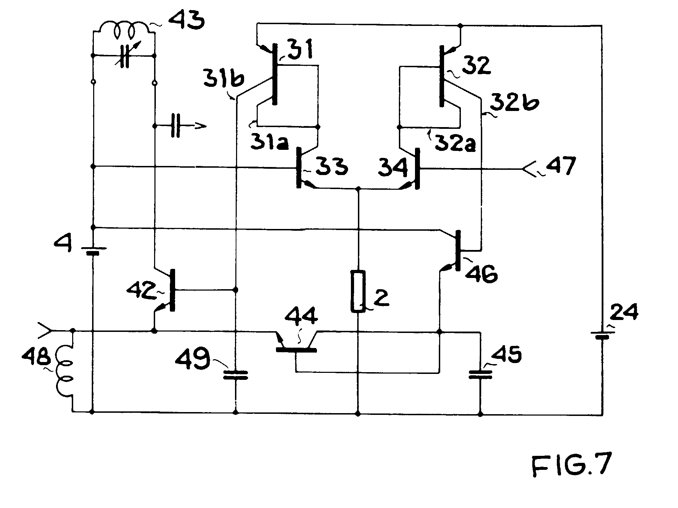

Die in den Figuren 6 und 7 beschriebenen erfindungsgemäßen Schaltungen beziehen sich auf die Steuerung von Kollektorströmen von npn-Transistoren. Die Steuerung von Kollektorströmen wird beispielsweise zur Steuerung der Verstärkung von Transistorstufen eingesetzt. Hierzu werden erfindungsgemäß die Basis-Emitterströme der zu steuernden Transistoren über ein Steuersignal geändert. Dabei ist es für spezielle Anwendungen erforderlich oder zweckmäßig, eine gegenläufige Steuerung von Kollektorströmen vorzusehen. Weiterhin kann es bei gegenläufiger Steuerung der Kollektorströme nötig sein, diese so auszuführen, daß die Summe dieser gesteuerten Ströme konstant bleibt.

Die Figur 6 zeigt eine erfindungsgemäße Schaltungsanordnung zur gegenläufigen Steuerung von zwei (nicht dargestellten) npn-Transistoren. In dieser Schaltung werden zwei Stromspiegelanordnungen 31 und 32 von den Kollektoren der Transistoren 33 und 34 angesteuert. Die Ausgangsströme, mit denen die npn-Transistoren gesteuert werden, werden den Kollektoren 31b bzw. 32b entnommen. Die Steuerung der Ausgangsströme erfolgt durch die Steuerung der Emitterstromverteilung der Transistoren 33 und 34 über die Änderung des Basispotentials des Transistors 34, z.B. über die variable Spannung der Quelle 35.

Die Figur 7 zeigt eine erfindungsgemäße Schaltung für den Einsatz in einer verstärkungsgeregelten Empfänger-Vorstufe. Bei der Schaltung nach Figur 7 dient der Transistor 42 als Verstärkertransistor in der Basis-Grundschaltung, bei der das Signal dem Emitter des Transistors 42 zugeführt wird, und das verstärkte Signal vom Kollektorkreis 43 abgenommen wird. Das verstärkte Signal wird z.B. einer nachgeschalteten Mischstufe zugeführt. Zur Steuerung der Signalverstärkung wird in dieser Schaltungsanordnung der Basis-Emittergleichstrom des Transistors 42 über den Kollektor 31b des Stromspiegeltransistors 31 gesteuert. Der als Diode geschaltete Transistor 44 hat die Aufgabe, beim Abwärtssteuern der Verstärkung den Eingangssignalstrom nach dem Bezugspotential über den Kondensator 45 abzuleiten. Hierzu wird der Transistor 44 über den Emittergleichstrom des Transistors 46 leitend gesteuert. Der Basisstrom für den Transistor 46 wird vom Kollektor 32b des Stromspiegeltransistors 32 geliefert. Die Steuerung der Stromverteilung für die Transistoren 42 und 46 erfolgt über das Basispotential des Transistors 34. Das Steuersignal 47 wird beispielsweise durch eine (nicht dargestellte) Regelsignalquelle geliefert. Die Steuerung erfolgt nach dem Prinzip der Schaltung nach Figur 6. Danach werden die Kollektorströme der Transistoren 42 und 46 gegensinnig gesteuert, wobei die Summe der gesteuerten Kollektorströme nahezu konstant bleibt. Damit wird z.B. erreicht, daß sich die Belastung der Stromversorgungsquelle 4 bei Steuerung der Verstärkung praktisch nicht ändert. Am Eingang der Schaltung liegt eine Spule 48, die eine gleichstrommäßige Verbindung zum Bezugspotential herstellt. Der Kondensator 49 hat dieselbe Funktion wie der Kondensator 45. Der Kondensator 50 trennt das Potential des Kollektors des Transistors 42 vom nachgeschalteten Teil der Schaltung (Mischstufe).

## Patentansprüche

1. Integrierte Schaltungsanordnung zur Arbeitspunkteinstellung eines Transistors (3) mit einer Stromspiegelschaltung (26; 1), die den Basisstrom des Transistors liefert, und mit einem Pinch-Widerstand (2), der den Eingangsstrom der Stromspiegelschaltung bestimmt, wobei die Reihenschaltung aus dem den Eingangsstrom der Stromspiegelschaltung bestimmenden Pinch-Widerstand, einem weiteren Transistor (23; 33), der die Stromspiegelschaltung ansteuert, und der Basis-Emitterstrecke des Stromspiegeltransistors an einer Spannungsquelle (24) liegt, dadurch gekennzeichnet, daß mehrere Stromspiegelschaltungen (26, 27; 31, 32) vorgesehen sind und daß jede Stromspiegelschaltung für sich von je einem Transistor (23, 25; 33, 34) angesteuert wird.

2. Schaltungsanordnung nach Anspruch 1, dadurch gekennzeichnet, daß die Emitter der die Stromspiegelschaltungen ansteuernden Transistoren (23, 25; 33, 34) miteinander verbunden sind.

3. Schaltungsanordnung nach Anspruch 2, dadurch gekennzeichnet, daß die Basen der die Stromspiegelschaltungen ansteuernden Transistoren (23, 25) miteinander verbunden sind.

4. Schaltungsanordnung nach Anspruch 3, dadurch gekennzeichnet, daß die die Stromspiegelschaltungen ansteuernden Transistoren(23, 25) unterschiedliche Emitterflächen aufweisen und daß die Ströme für die Stromspiegelschaltungen durch die Emitterflächen der die Stromspiegelschaltungen ansteuernden Transistoren bestimmt werden.

5. Schaltungsanordnung nach einem der Ansprüche 1 bis 4, dadurch gekennzeichnet, daß die Basis-Emitterströme derjenigen Transistoren, deren Arbeitspunkte unterschiedlich einzustellen sind, steuerbar sind.

6. Schaltungsanordnung nach Anspruch 2, dadurch gekennzeichnet, daß durch die Basispotentiale der die Stromspiegeltransistoren steuernden Transistoren (33, 34) die Basisströme für die Stromspiegeltransistoren gesteuert werden.

7. Schaltungsanordnung nach einem der Ansprüche 1 bis 6, dadurch gekennzeichnet, daß die Transistoren (42, 46), deren Arbeitspunkt eingestellt wird, in einer Verstärkerschaltung Anwendung finden.

8. Schaltungsanordnung nach einem der Anspruch 7, dadurch gekennzeichnet, daß bei Verwendung der Transistoren (42, 46) in der Verstärkerschaltung die Basisströme dieser Transistoren gegensinnig gesteuert werden.

9. Verstärkerschaltung nach Anspruch 8, dadurch gekennzeichnet, daß bei gegensinniger Steuerung der Transistoren (42, 46) die Summe der Basisströme dieser Transistoren konstant gehalten wird.

## Claims

1. Integrated circuit arrangement for setting the working point of a transistor (3) using a current mirror circuit (26; 1) that furnishes the base current for the transistor and including a pinch resistor (2) which determines the input current of the current mirror circuit, wherein the series circuit consisting of the pinch resistor that determines the input current of the current mirror circuit, a further transistor (23; 33) that drives the current mirror circuit and the base-emitter path of the current mirror transistor is connected to a voltage source (24), characterised in that, there are provided a plurality of current mirror circuits (26, 27; 31, 32) and that each current mirror circuit is driven by a transistor (23, 25; 33, 34) unique thereto.

2. Circuit arrangement in accordance with Claim 1, characterised in that, the emitters of the transistors (23, 25; 33, 34) driving the current mirror circuits are connected together.

3. Circuit arrangement in accordance with Claim 2, characterised in that, the bases of the transistors (23, 25) driving the current mirror circuits are connected together.

4. Circuit arrangement in accordance with Claim 3, characterised in that, the transistors (23, 25) driving the current mirror circuits have differing emitter areas and that the currents for the current mirror circuits are determined by the emitter areas of the transistors driving the current mirror circuits.

5. Circuit arrangement in accordance with any of the Claims 1 to 4, characterised in that, the base-emitter currents of those transistors whose working points are to be differently set are controllable.

6. Circuit arrangement in accordance with Claim 2, characterised in that, the base currents for the current mirror transistors are controlled by the base potentials of the transistors (33, 34) controlling the current mirror circuits.

7. Circuit arrangement in accordance with any of the Claims 1 to 6, characterised in that, the transistors (42, 46) whose working point is set are used in an amplifier circuit.

8. Circuit arrangement in accordance with one of the {sic} Claim 7, characterised in that, the base currents of the transistors are controlled in opposite senses when these transistors (42, 46) are being used in the amplifier circuit.

9. Amplifier circuit in accordance with Claim 8, characterised in that, the sum of the base currents of the transistors is kept constant when these transistors (42, 46) are being controlled in opposite senses.

## Revendications

1. Circuit intégré pour l'ajustement du point de fonctionnement d'un transistor (3), comportant un circuit (26; 1), symétrique au point de vue du courant, qui fournit le courant de base du transistor et comportant une résistance à base pincée (2) qui détermine le courant d'entrée du circuit symétrique au point de vue du courant, dans lequel le circuit de série, constitué de la résistance à base pincée qui détermine le courant d'entrée du circuit, symétrique au point de vue du courant, d'un autre transistor (23; 33) qui active le circuit symétrique au point de vue du courant, et du circuit base-émetteur du transistor symétrique au point de vue du courant, est relié à une source de courant (24), caractérisé par le fait que plusieurs circuits, symétriques au point de vue du courant, (26, 27; 31, 32) sont prévus et que chaque circuit symétrique au point de vue du courant est activé pour soi par, chacun, un transistor (23, 35; 33, 34).

2. Circuit selon la revendication 1, caractérisé par le fait que les émetteurs des transistors (23, 25, 33, 34) qui activent les circuits symétriques au point de vue du courant sont reliés entre eux.

3. Circuit selon la revendication 2, caractérisé par le fait que les bases des transistors (23, 25) qui activent les circuits symétriques au point de vue du courant sont reliées entre elles.

4. Circuit selon la revendication 3, caractérisé par le fait que les transistors (23, 25) qui activent les circuits symétriques au point de vue du courant présentent des surfaces d'émetteur différentes et que les courants pour les circuits symétriques au point de vue du courant sont déterminés par les surfaces d'émetteur des transistors qui activent les circuits symétriques au point de vue du courant.

5. Circuit selon l'une des revendications 1 à 4, caractérisé par le fait que les courants base-émetteur des transistors dont les points de fonctionnement sont à ajuster différemment peuvent être commandés.

6. Circuit selon la revendication 2, caractérisé par le fait que les courants de base pour les transistors symétriques au point de vue du courant sont commandés par les potentiels de base des transistors (33, 34) qui commandent les transistors symétriques au point de vue du courant.

7. Circuit selon l'une des revendications 1 à 6, caractérisé par le fait que les transistors (42, 46) dont on ajuste le point de fonctionnement trouvent application dans un circuit amplificateur.

8. Circuit selon l'une des revendications 1 à 7, caractérisé par le fait que dans le cas de l'emploi du transistor (42, 46) dans le circuit amplificateur, les courants de base de ces transistors sont commandés en sens opposé.

9. Circuit amplificateur selon la revendication 8, caractérisé par le fait que, dans le cas de la commande des transistors (42, 46) dans le sens opposé, la somme du courant de base de ces transistors est maintenue constante.
